(19) **Europäisches Patentamt**
**European Patent Office**
**Office européen des brevets**

(11) **EP 2 284 628 B1**

(12) **FASCICULE DE BREVET EUROPEEN**

(45) Date de publication et mention
de la délivrance du brevet:
**25.03.2015 Bulletin 2015/13**

(51) Int Cl.:
***G04B 17/06*** (2006.01) ***H03H 3/04*** (2006.01)
***H03H 9/21*** (2006.01)

(21) Numéro de dépôt: **10172464.9**

(22) Date de dépôt: **11.08.2010**

(54) **Résonateur mécanique thermocompensé**

Thermokompensierter mechanischer Resonator

Thermocompensated mechanical resonator

(84) Etats contractants désignés:
**AL AT BE BG CH CY CZ DE DK EE ES FI FR GB
GR HR HU IE IS IT LI LT LU LV MC MK MT NL NO
PL PT RO SE SI SK SM TR**

(30) Priorité: **13.08.2009 EP 09167805**

(43) Date de publication de la demande:
**16.02.2011 Bulletin 2011/07**

(73) Titulaire: **ETA SA Manufacture Horlogère Suisse
2540 Grenchen (CH)**

(72) Inventeurs:
• **Cusin, Pierre
1423, Villars-Burquin (CH)**

• **Cabezas Jurin, Andrés
1400, Yverdon (CH)**

(74) Mandataire: **Couillard, Yann Luc Raymond et al
ICB
Ingénieurs Conseils en Brevets SA
Faubourg de l'Hôpital 3
2001 Neuchâtel (CH)**

(56) Documents cités:
**EP-A- 0 732 635        EP-A- 1 422 436
EP-A- 1 791 039        WO-A-2009/068091
WO-A1-2008/043727**

**Description**

Domaine de l'invention

L'invention se rapporte à un résonateur mécanique thermocompensé et plus particulièrement à un tel résonateur comportant un ressort-spiral en silicium monocristallin thermocompensé.

Arrière plan de l'invention

Le document EP 1 422 436 divulgue un ressort-spiral dont l'âme est en silicium monocristallin qui est recouvert par un revêtement de dioxyde de silicium afin de compenser thermiquement ledit ressort-spiral. Il permet ainsi de minimiser la variation du coefficient thermoélastique en fonction de la température. Cependant, le document se borne à divulguer un revêtement d'épaisseur égale ce qui peut rendre difficile son adaptation à un balancier pour obtenir un résonateur comportant un écart de marche minimal.

WO 2008/043727 décrit un résonateur mécanique thermocompensé en forme de diapason et présentant des lames rectilignes en silicium avec des revêtements supérieur et inférieur en oxyde de silicium.

Résumé de l'invention

Le but de la présente invention est de pallier tout ou partie les inconvénients cités précédemment en proposant un résonateur comportant plus de degrés de liberté quant à la formation de son revêtement autorisant la compensation thermique.

À cet effet, l'invention se rapporte à un résonateur mécanique tel que défini dans les revendications indépendantes 1 et 2.

Conformément à d'autres caractéristiques avantageuses de l'invention :

- la section de la lame est un quadrilatère dont les faces sont identiques deux à deux ;
- le dépôt dudit revêtement est réalisé sur les faces parallèles par rapport au plan de flexion de la lame afin d'améliorer quantitativement l'influence sur la fréquence dudit résonateur ou, inversement, sur les faces perpendiculaires pour modifier avec moins d'influence la fréquence dudit résonateur par rapport au dépôt sur les faces parallèles ;
- ladite lame enroulée sur elle-même forme au moins une spire et est couplée avec un volant d'inertie ;
- le revêtement comporte du dioxyde de silicium ;
- l'âme est réalisée à partir d'une plaque d'un plan de coupe {100} ou {111} de silicium monocristallin ;
- les épaisseurs de revêtement suivant le plan de coupe {100} ou {111} desdites faces deux à deux suivent sensiblement la relation :

$$Y = A \cdot X^3 + B \cdot X^2 + C \cdot X + D$$

Où :

- *Y* représente le pourcentage d'épaisseur du revêtement sur les faces parallèles à l'axe ($A_1$) de flexion de la lame par rapport à la hauteur (h) totale de la lame ;
- *X* représente le pourcentage d'épaisseur du revêtement sur les faces perpendiculaires à l'axe ($A_1$) de flexion de la lame par rapport à la base (b) totale de la lame ;
- *A* représente le coefficient du troisième degré du polynôme d'estimation de la courbe caractéristique qui s'élève à $-3{,}5302.10^{-5}$ ou $-3{,}5565.10^{-5}$ ;
- *B* représente le coefficient du deuxième degré du polynôme d'estimation de la courbe caractéristique qui s'élève à $-1{,}114.10^{-3}$ ou $-1{,}0642.10^{-3}$ ;
- *C* représente le coefficient du premier degré du polynôme d'estimation de la courbe caractéristique qui s'élève à $-0{,}29152$ ou
- $0{,}28721$ ;
- *D* représente l'unité du polynôme d'estimation de la courbe caractéristique qui s'élève à 15,522 ou 16,446.

L'invention se rapporte à une pièce d'horlogerie comportant au moins un résonateur conforme à l'une des variantes précédemment citées.

Description sommaire des dessins

D'autres particularités et avantages ressortiront clairement de la description qui en est faite ci-après, à titre indicatif et nullement limitatif, en référence aux dessins annexés, dans lesquels :

- la figure 1 est une représentation générale en perspective d'un ressort-spiral ;
- la figure 2 est une section représentative du ressort-spiral de la figure 1 ;
- la figure 3 est une représentation de plusieurs modes de réalisation selon l'invention ;
- la figure 4 est une représentation spatiale du module d'Young de la coupe {100} d'un silicium monocristallin en fonction de son orientation ;
- la figure 5 est une représentation de la variation du module d'Young de la coupe {100} d'un silicium monocristallin en fonction de sa température ;
- la figure 6 est une représentation spatiale du module d'Young de la coupe {111} d'un silicium monocristallin en fonction de son orientation ;
- la figure 7 est une représentation de la variation du module d'Young de la coupe {111} d'un silicium monocristallin en fonction de sa température ;

- la figure 8 est une représentation de la variation de fréquence du résonateur dont la lame est issue de la coupe {100} d'un silicium monocristallin en fonction de sa température et des épaisseurs de revêtement ;
- la figure 9 est une représentation verticale d'une partie de la figure 8 selon la direction de l'axe $b_1+b_3$ [%b] ;
- la figure 10 est une représentation verticale d'une partie de la figure 8 selon la direction de l'axe $h_1+h_3$ [%h] ;
- la figure 11 est une représentation horizontale d'une partie de la figure 8 selon la direction $\Delta F=1$ ;
- les figures 12 et 13 sont des représentations de la variation de fréquence du résonateur en fonction de la localisation et de l'épaisseur du revêtement ;
- la figure 14 est une représentation de la variation de fréquence du résonateur dont la lame est issue de la coupe {111} d'un silicium monocristallin en fonction de sa température et des épaisseurs de revêtement ;
- la figure 15 est une représentation verticale d'une partie de la figure 14 selon la direction de l'axe $b_1+b_3$ [%b] ;
- la figure 16 est une représentation verticale d'une partie de la figure 14 selon la direction de l'axe $h_1+h_3$ [%h] ;
- la figure 17 est une représentation horizontale d'une partie de la figure 14 selon la direction $\Delta F=1$.

Description détaillée des modes de réalisation préférés

L'invention se rapporte à un résonateur mécanique qui peut être du type balancier-spiral, ou plus généralement du type MEMS (abréviation provenant des termes anglais « Micro Electro Mechanical System »).

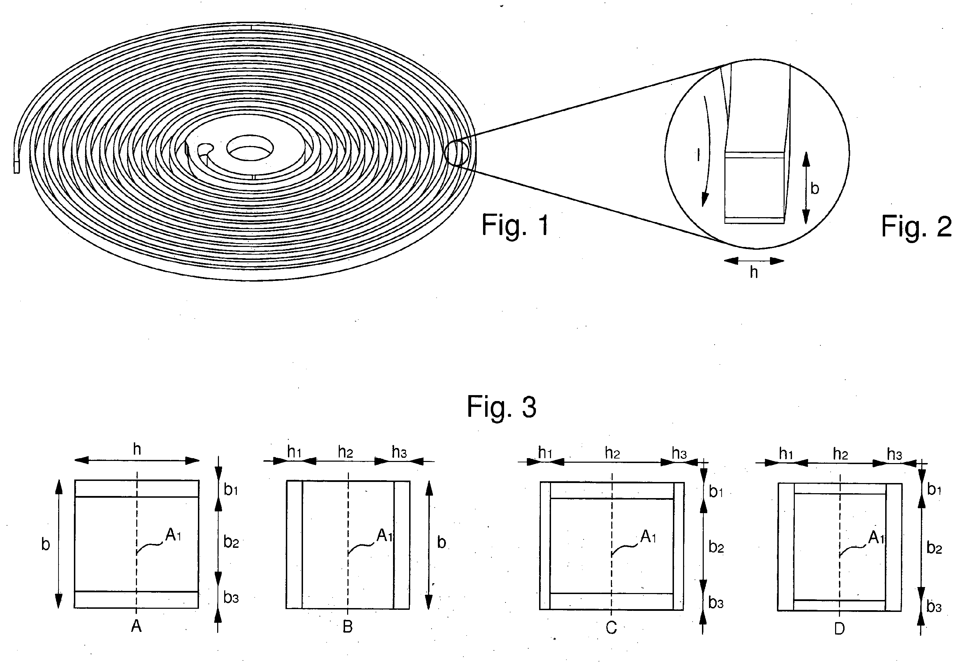

Cependant, pour l'explication de l'invention, on utilise, comme illustré aux figures 1 et 2, l'application à un ressort-spiral destiné à coopérer avec un balancier afin de former ledit résonateur mécanique. Le ressort-spiral est formé généralement par une lame enroulée en au moins une spire de longueur l et dont la section comporte une base b et une hauteur h.

Comme illustré à la figure 1, la lame est préférentiellement formée en une seule pièce avec sa virole. De manière préférée, cela est rendu possible par l'utilisation d'une plaquette de silicium monocristallin d'une épaisseur sensiblement correspondante à la grandeur de la base b, laquelle plaquette est gravée de part en part selon la forme du ressort-spiral et de sa virole à l'aide d'un gravage ionique réactif profond (également connu sous l'abréviation anglaise « DRIE »).

Comme illustré à la figure 2, on peut voir que la grandeur totale de la base b est formée par le silicium monocristallin mais également par deux revêtements opposés préférentiellement en dioxyde de silicium amorphe ($SiO_2$). Ce premier mode de réalisation est mieux représenté à la figure 3 au dessus de la référence A. A cette même figure 3, on remarque la ligne en traits interrompus nommée $A_1$ qui représente l'axe de flexion de la lame. Ainsi, dans le premier mode de réalisation A, seules les faces de la lame qui sont perpendiculaires à l'axe de flexion $A_1$ sont recouvertes par un revêtement selon les épaisseurs respectives $b_1$ et $b_3$. On comprend donc que la grandeur totale b de la base est donc formée par ces revêtements $b_1$ et $b_3$, et de la grandeur $b_2$ de la partie en silicium monocristallin.

Dans le deuxième mode de réalisation B de la figure 3, seules les faces de la lame qui sont parallèles à l'axe de flexion $A_1$ sont recouvertes par un revêtement selon les épaisseurs respectives $h_1$ et $h_3$. On comprend donc que la grandeur totale h de la hauteur est donc formée par ces revêtements $h_1$ et $h_3$, et de la grandeur $h_2$ de la partie en silicium monocristallin.

Dans le troisième mode de réalisation C de la figure 3, toutes les faces de la lame sont recouvertes par un revêtement. Les faces adjacentes de la lame ne sont pas revêtues de la même manière et, préférentiellement, sont identiques deux à deux. Ainsi, les faces qui sont parallèles à l'axe de flexion $A_1$ sont recouvertes par un revêtement selon les épaisseurs respectives $h_1$ et $h_3$ et celles qui sont perpendiculaires à l'axe de flexion $A_1$ sont recouvertes par un revêtement selon les épaisseurs respectives $b_1$ et $b_3$. On comprend donc que, d'une part, la grandeur totale h de la hauteur est donc formée par les revêtements $h_1$ et $h_3$, et de la grandeur $h_2$ de la partie en silicium monocristallin et, d'autre part, la grandeur totale b de la base est donc formée par les revêtements $b_1$ et $b_3$, et de la grandeur $b_2$ de la partie en silicium monocristallin. On remarque que les grandeurs $h_1$, $h_3$ sont plus petites que les grandeurs $b_1$, $b_3$.

Dans le quatrième mode de réalisation D de la figure 3, toutes les faces de la lame sont recouvertes par un revêtement de manière similaire au troisième mode de réalisation C. Les faces adjacentes de la lame ne sont pas revêtues de la même manière et, préférentiellement, sont identiques deux à deux. De manière opposée au troisième mode C de réalisation, les grandeurs $h_1$, $h_3$ sont plus grandes que les grandeurs $b_1$, $b_3$.

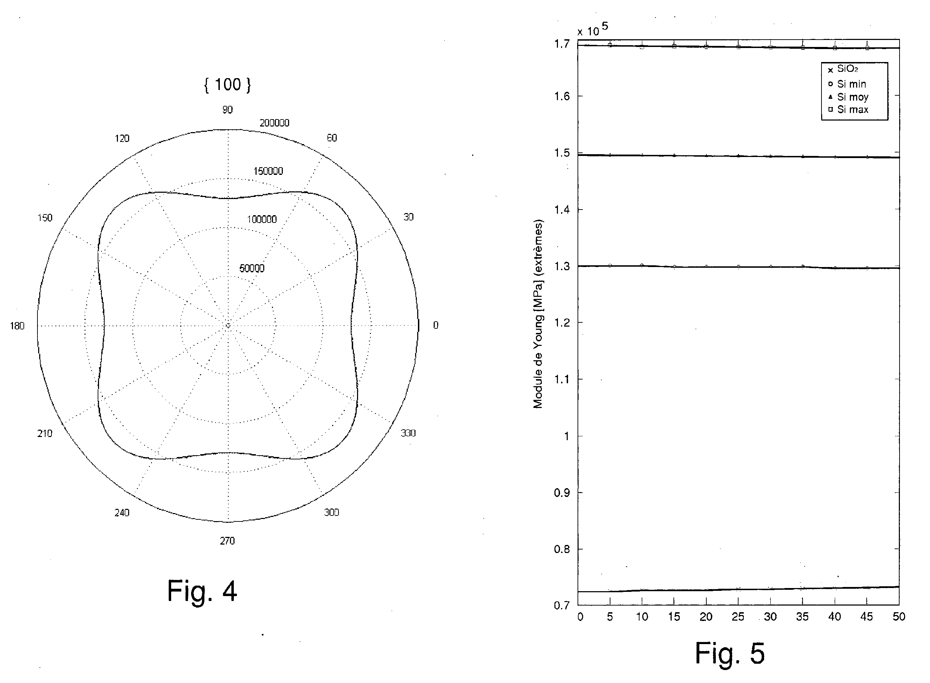

Selon l'invention, les quatre modes de réalisation A, B, C et D ont été étudiés à partir d'une lame formée dans une plaquette en silicium monocristallin coupée selon les plans {100} et {111}. Dans l'exemple illustré à la figure 4, on peut voir une représentation spatiale du module d'Young de la coupe {100} d'un silicium monocristallin en fonction de son orientation. On comprend ainsi que l'élasticité est variable suivant l'orientation de la flexion de la lame. Cependant, après calculs, on s'aperçoit que la construction de la lame en spirale se comporte en fait comme si elle avait un module d'Young moyen ($\Delta Si_{moy}$) comme illustré à la figure 5. A cette même figure, on peut voir que le coefficient thermo-élastique du silicium monocristallin est négatif (voir les repères □, ○, △) alors que celui du dioxyde de silicium amorphe ($SiO_2$) est positif (voir le repère x).

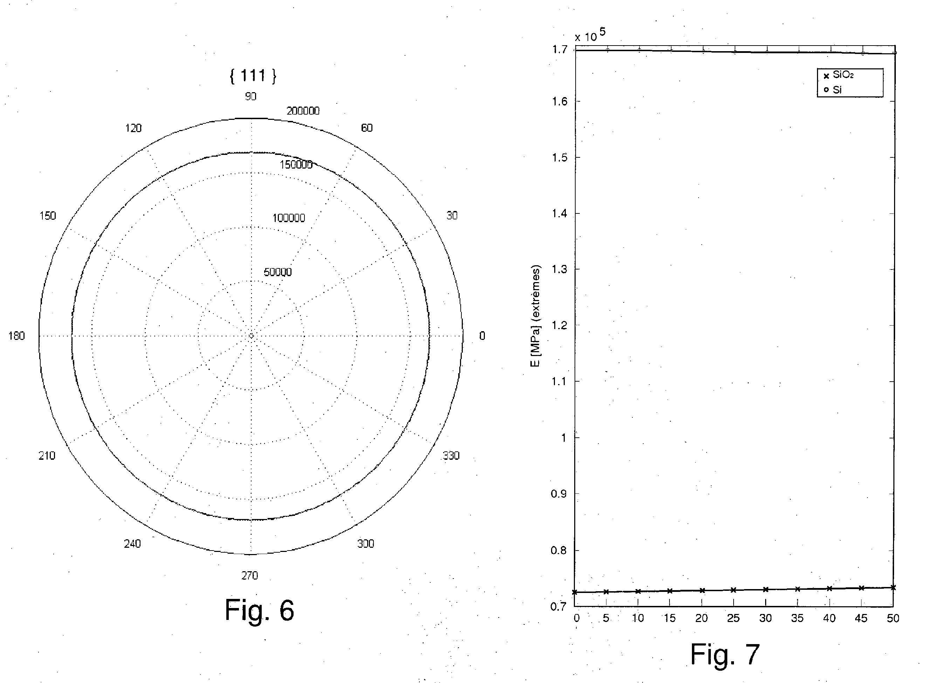

Ainsi, confronté aux figures 6 et 7, similaires respectivement aux figures 4 et 5 mais pour le plan de coupe {111}, on s'aperçoit qu'à part la valeur plus élevé du module d'Young, la lame formée à partir du plan {111} réagit de manière similaire à celle formée à partir du plan {100}, c'est-à-dire qu'elle peut être compensée par un revêtement de dioxyde de silicium amorphe ($SiO_2$).

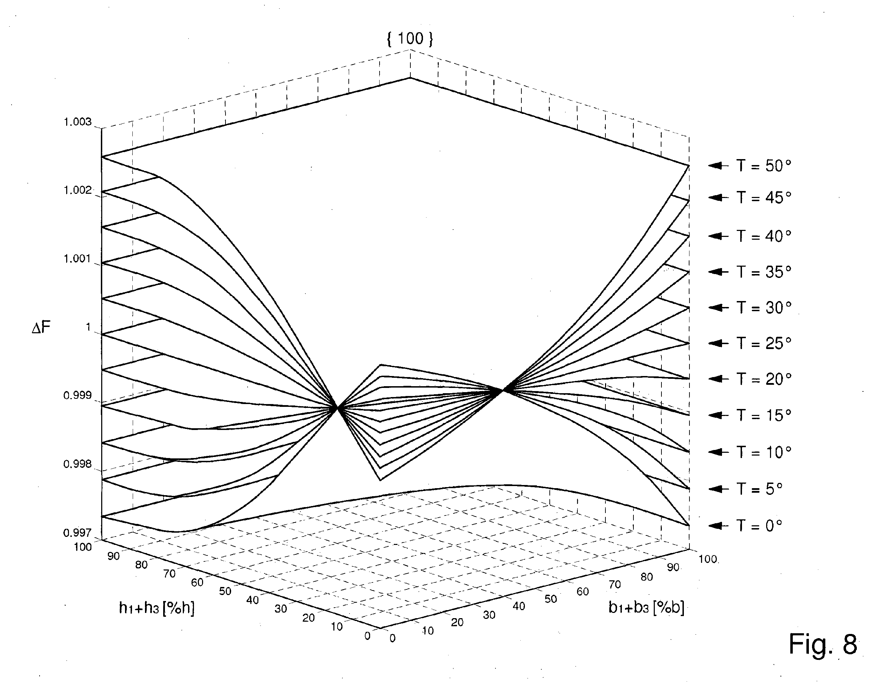

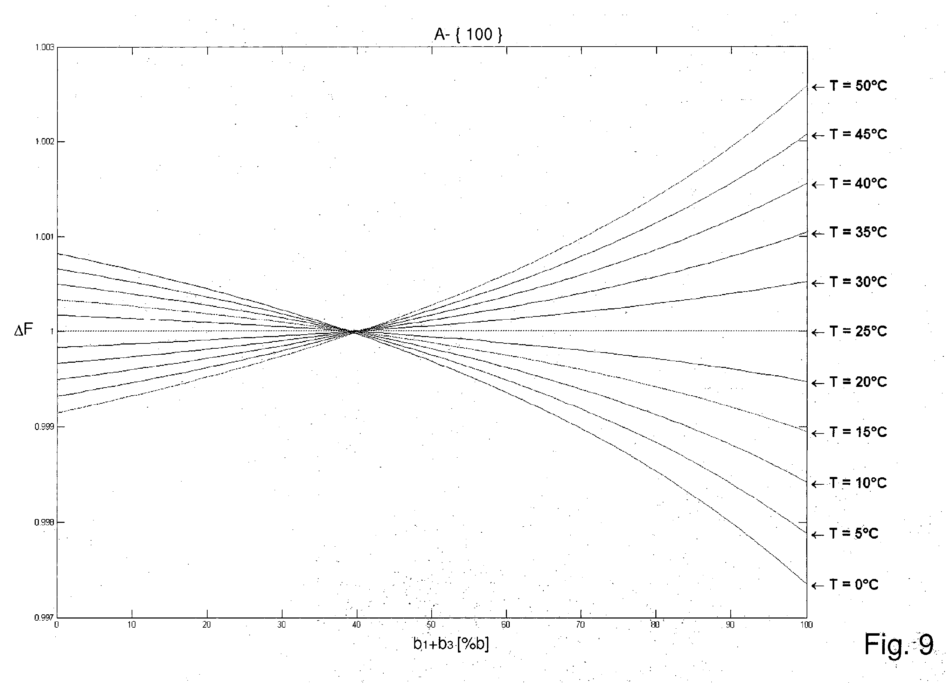

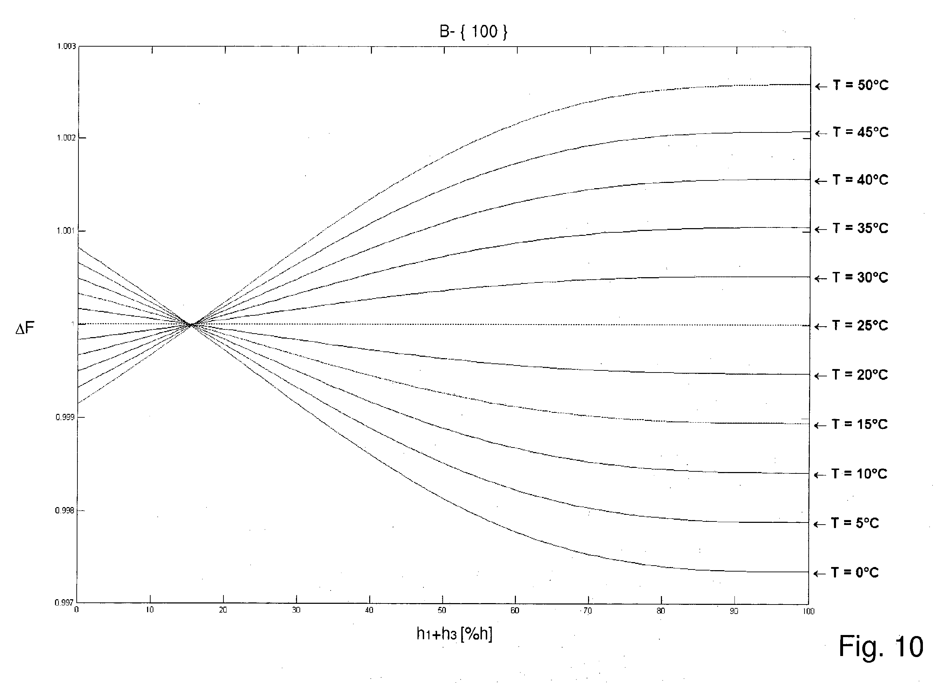

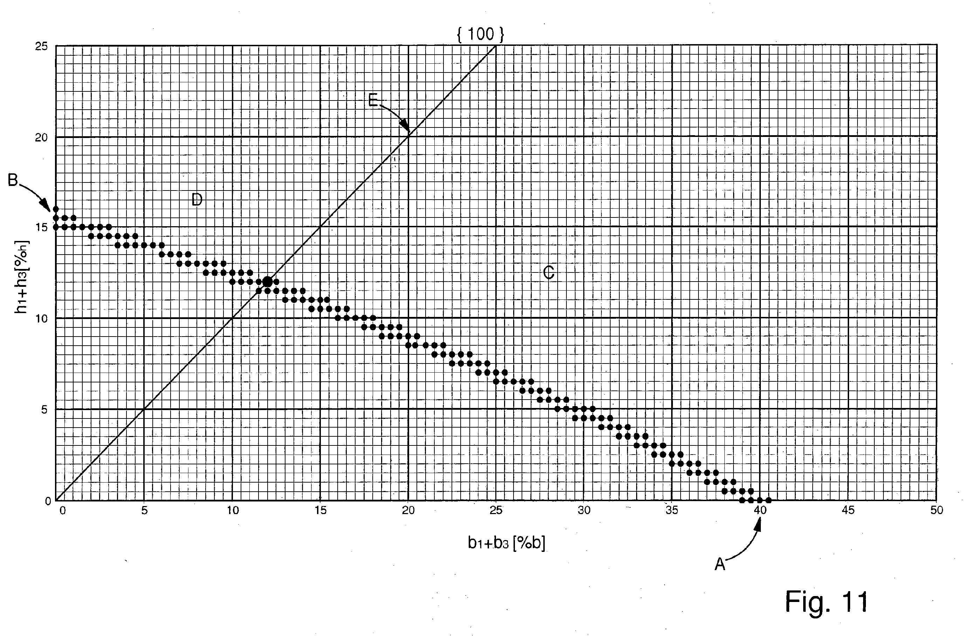

La figure 8 est une représentation complète des calculs effectués pour une lame formée dans une plaquette en silicium monocristallin coupée selon le plan {100}. La figure 8 présente la variation de fréquence du résonateur dont la lame est issue de la coupe {100} d'un silicium monocristallin en fonction de sa température et des épaisseurs de revêtement. On s'aperçoit qu'il y a une courbe de convergence entre les différents plans thermiques permettant d'obtenir un rapport ΔF sensiblement constant, c'est-à-dire égal à 1. Afin de mieux se rendre compte des courbes caractéristiques, un plan vertical d'une partie de la figure 8 selon la direction de l'axe $b_1+b_3$ [%b], c'est-à-dire %h=0 (figure 9), un autre selon la direction de l'axe $h_1+h_3$ [%h], c'est-à-dire %b=0 (figure 10) puis, enfin, un plan horizontal de la figure 8 selon la direction ΔF=1 (figure 11) ont été réalisés.

Grâce à la figure 9, qui est en fait la courbe de thermocompensation du premier mode de réalisation A de la figure 3, on voit que les courbes thermiques convergent vers celle de 25°C au niveau du pourcentage $b_1+b_3$ par rapport à b sensiblement compris entre 39 et 41%. Pour notre cas préféré dans lequel chaque face opposée respecte la relation $b_1 = b_3$, on a donc une épaisseur de revêtement pour le premier mode de réalisation A, pour chacune des deux faces, comprise entre 19,5 et 20,5%. Après un calcul plus fin, la valeur $b_1+b_3$ est estimée autour de 39,65%.

De manière similaire, à l'aide de la figure 10, qui est la courbe de thermocompensation du deuxième mode de réalisation B de la figure 3, on voit que les courbes thermiques convergent vers celle de 25°C au niveau du pourcentage $h_1+h_3$ par rapport à h sensiblement compris entre 15 et 16%. Pour notre cas préféré dans lequel chaque face opposée respecte la relation $h_1 = h_3$, on a donc une épaisseur de revêtement pour le premier mode de réalisation B, pour chacune des deux faces, comprise entre 7,5 et 8%. Après un calcul plus fin, la valeur $h_1+h_3$ est estimée autour de 15,49%.

La figure 11 permet de résumer la courbe à respecter pour compenser une lame formée d'une plaquette en silicium monocristallin coupée selon le plan {100} avec des revêtements en dioxyde de silicium amorphe ($SiO_2$). Ainsi, on retrouve les valeurs des premier et deuxième modes de réalisation A et B sur respectivement les abscisses et les ordonnées. De plus, on retrouve la courbe annotée E pour laquelle, le même pourcentage est appliqué sur toutes les faces de la lame, c'est-à-dire comme dans le document EP 1 422 436. Enfin, on peut voir que la courbe caractéristique entre le point B et la courbe E appartient au quatrième mode de réalisation D de la figure 3 et, entre la courbe E et le point A, au troisième mode de réalisation C de la figure 3.

Afin de simplifier la détermination des couches à former, un polynôme du troisième degré a été calculé afin de plus facilement mettre au point le résonateur :

$$Y = A \cdot X^3 + B \cdot X^2 + C \cdot X + D$$

Où :

- $Y$ représente le pourcentage d'épaisseur du revêtement ($h_1+h_3$) sur les faces parallèles à l'axe ($A_1$) de flexion de la lame par rapport à la hauteur (h) totale de la lame ;
- $X$ représente le pourcentage d'épaisseur du revêtement ($b_1+b_3$) sur les faces perpendiculaires à l'axe ($A_1$) de flexion de la lame par rapport à la base (b) totale de la lame ;
- $A$ représente le coefficient du troisième degré du polynôme d'estimation de la courbe caractéristique qui s'élève à $-3,5302.10^{-5}$ ;
- $B$ représente le coefficient du deuxième degré du polynôme d'estimation de la courbe caractéristique qui s'élève à $-1,114.10^{-3}$ ;
- $C$ représente le coefficient du premier degré du polynôme d'estimation de la courbe caractéristique qui s'élève à $-0,29152$ ;
- $D$ représente l'unité du polynôme d'estimation de la courbe caractéristique qui s'élève à 15,522.

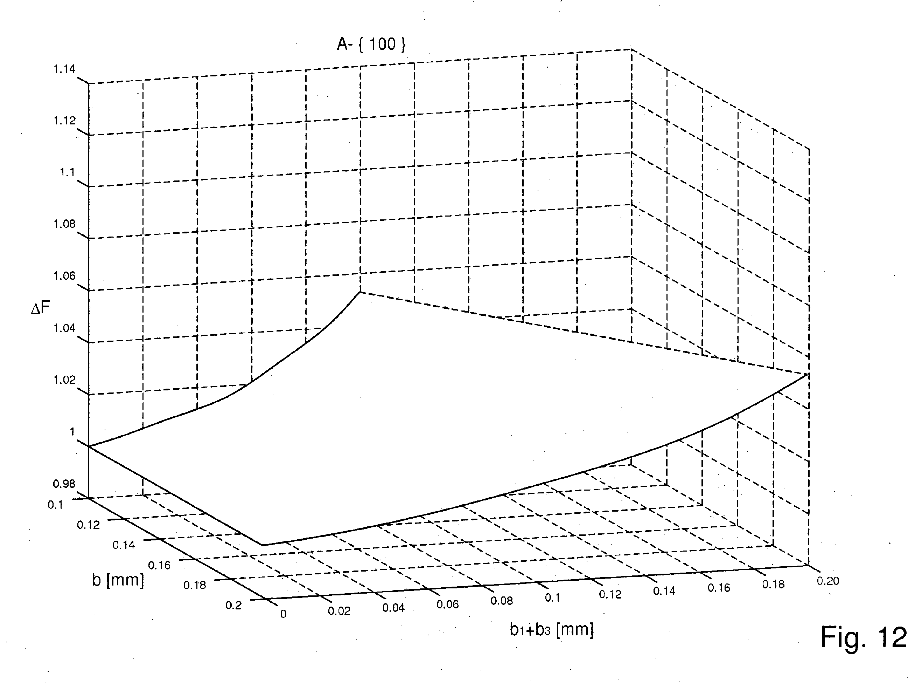

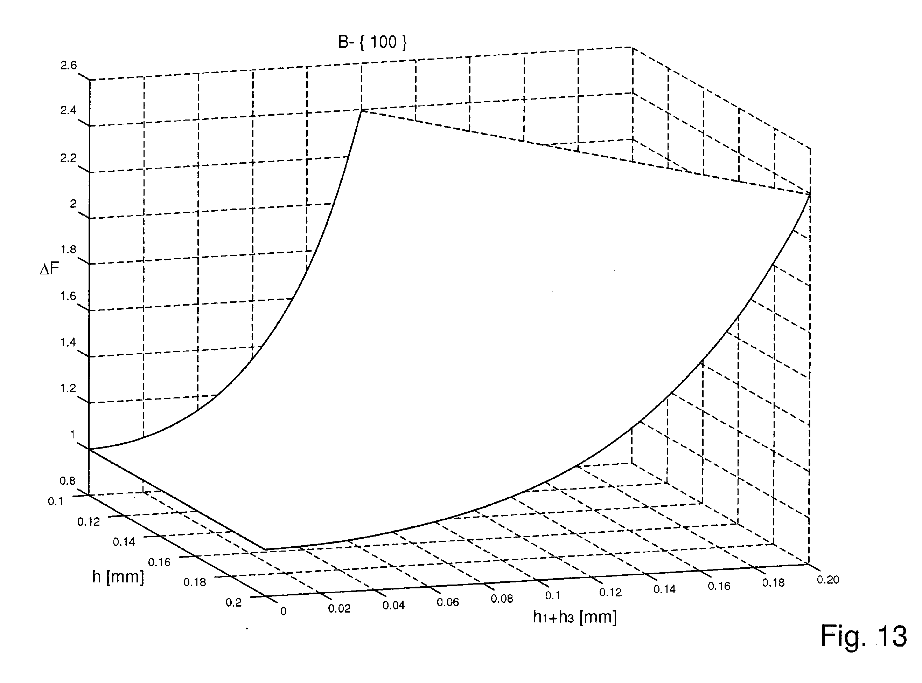

Enfin, les figures 12 et 13 montrent respectivement, de manière théorique, l'influence sur la fréquence du résonateur suivant que les revêtements recouvrent soit les faces perpendiculaires à l'axe de flexion $A_1$ (mode de réalisation A) soit les faces parallèles à l'axe de flexion $A_1$ (mode de réalisation B). On remarque que la fréquence sera beaucoup plus influencée quantitativement par un revêtement apporté sur les faces parallèles à l'axe de flexion $A_1$ (mode de réalisation B) que par un revêtement apporté sur les faces perpendiculaires à l'axe de flexion $A_1$ (mode de réalisation A). On en déduit donc que suivant l'adaptation à faire entre le spiral et le balancier pour former le résonateur, un des modes de réalisation A, B, C, D, E sera plus favorisé que les autres.

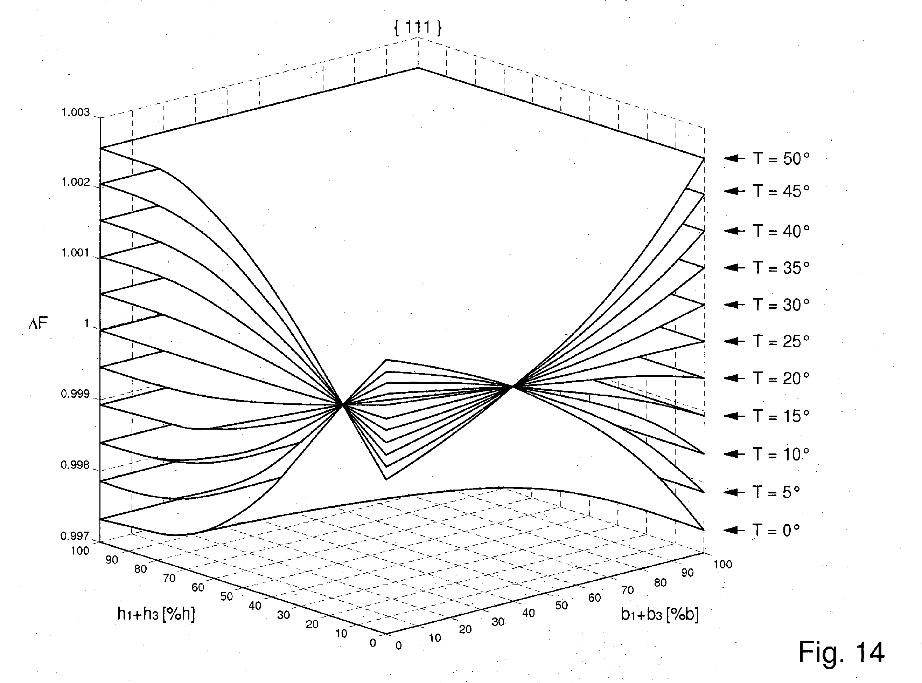

L'étude effectuée pour le plan de coupe {100} de la plaquette a également été effectuée pour le plan de coupe {111}. Ainsi, la figure 14 est une représentation complète des calculs effectués pour une lame formée dans une plaquette en silicium monocristallin coupée selon les plans {111}.

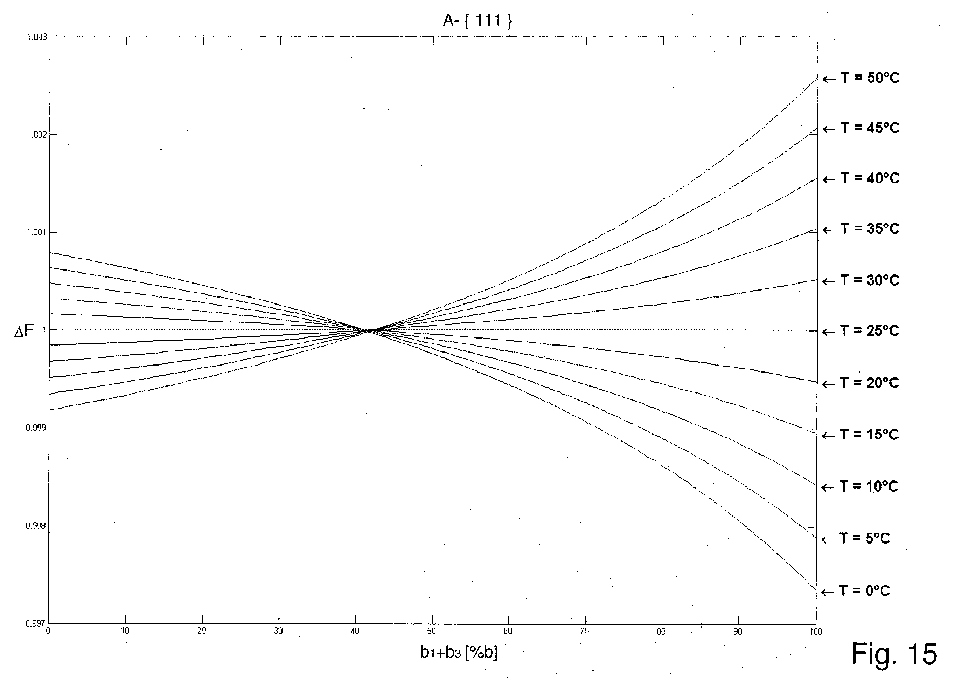

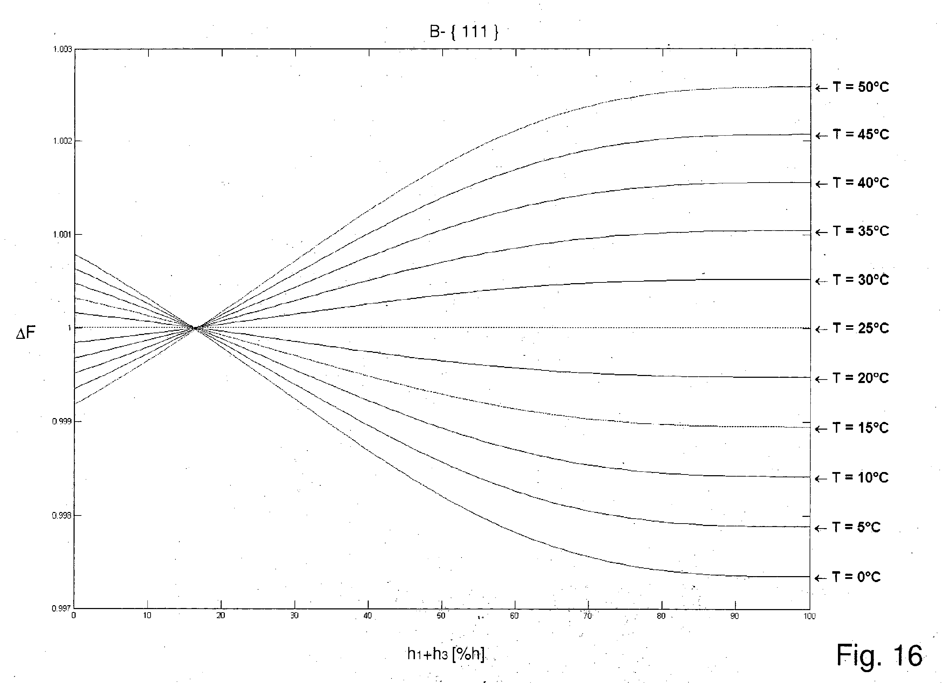

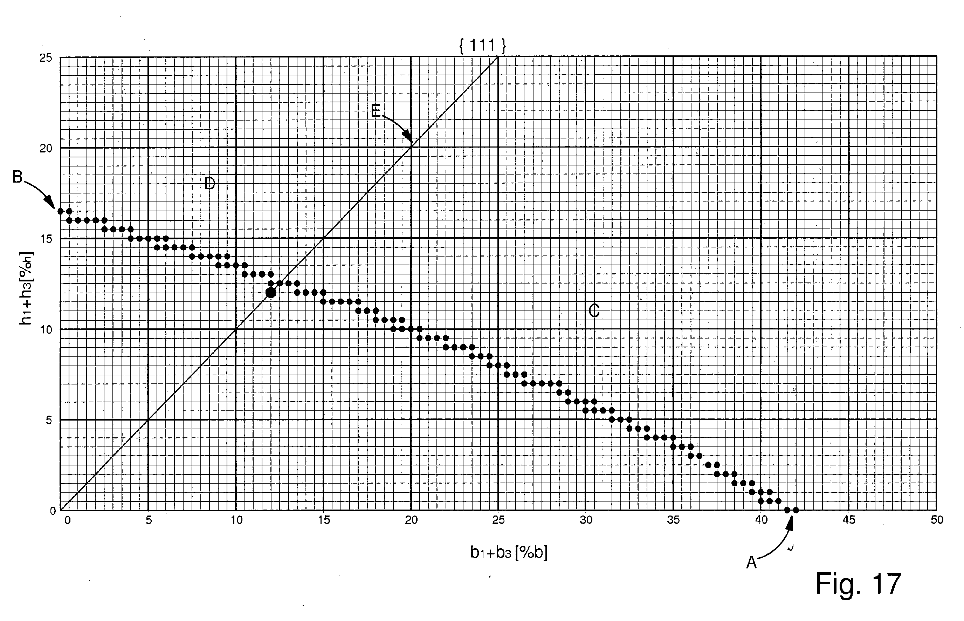

La figure 14 présente la variation de fréquence du résonateur dont la lame est issue de la coupe {111} d'un silicium monocristallin en fonction de sa température et des épaisseurs de revêtement. On s'aperçoit qu'il y a également une courbe de convergence entre les différents plans thermiques permettant d'obtenir de garder un rapport ΔF sensiblement constant, c'est-à-dire égal à 1. Afin de mieux se rendre compte des courbes caractéristiques, un plan vertical d'une partie de la figure 14 selon la direction de l'axe $b_1+b_3$ [%b], c'est-à-dire %h=0 (figure 15), un autre selon la direction de l'axe $h_1+h_3$ [%h], c'est-à-dire %b=0 (figure 16) puis, enfin, un plan horizontal de la figure 14 selon la direction ∆F=1 (figure 17) ont été réalisés.

Grâce à la figure 15, qui est en fait la courbe de thermocompensation du premier mode de réalisation A de la figure 3, on voit que les courbes thermiques convergent vers celle de 25°C au niveau du pourcentage $b_1+b_3$ par rapport à b sensiblement compris entre 41 et 43%. Pour notre cas préféré dans lequel chaque face opposée respecte la relation $b_1 = b_3$, on a donc une épaisseur de revêtement pour le premier mode de réalisation A, pour chacune des deux faces, comprise entre 20,5 et 21,5%. Après un calcul plus fin, la valeur $b_1+b_3$ est estimée autour de 41,69%.

De manière similaire, à l'aide de la figure 16, qui est la courbe de thermocompensation du deuxième mode de réalisation B de la figure 3, on voit que les courbes thermiques convergent vers celle de 25°C au niveau du pourcentage $h_1+h_3$ par rapport à h sensiblement compris entre 16 et 17%. Pour notre cas préféré dans lequel chaque face opposée respecte la relation $h_1 = h_3$, on a donc une épaisseur de revêtement pour le premier mode de réalisation B, pour chacune des deux faces, comprise entre 8 et 8,5%. Après un calcul plus fin, la valeur $h_1+h_3$ est estimée autour de 16,46%.

La figure 17 permet de résumer la courbe à respecter pour compenser une lame formée d'une plaquette en silicium monocristallin coupée selon le plan {111} avec des revêtements en dioxyde de silicium amorphe ($SiO_2$). Ainsi, on retrouve les valeurs des premier et deuxième modes de réalisation A et B sur respectivement les abscisses et les ordonnées. De plus, on retrouve la courbe annotée E pour laquelle, le même pourcentage est appliqué sur toutes les faces de la lame, c'est-à-dire comme dans le document EP 1 422 436. Enfin, on peut voir que la courbe caractéristique entre le point B et la courbe E appartient au quatrième mode de réalisation D de la figure 3 et, entre la courbe E et le point A, au troisième mode de réalisation C de la figure 3.

Afin de simplifier la détermination des couches à former, un polynôme du troisième degré a été calculé afin de plus facilement mettre au point le résonateur :

$$ Y = A \cdot X^3 + B \cdot X^2 + C \cdot X + D $$

Où :

- $Y$ représente le pourcentage d'épaisseur du revêtement ($h_1+h_3$) sur les faces parallèles à l'axe ($A_1$) de flexion de la lame par rapport à la hauteur (h) totale de la lame ;
- $X$ représente le pourcentage d'épaisseur du revêtement ($b_1+b_3$) sur les faces perpendiculaires à l'axe ($A_1$) de flexion de la lame par rapport à la base (b) totale de la lame ;
- $A$ représente le coefficient du troisième degré du polynôme d'estimation de la courbe caractéristique qui s'élève à $-3,5565 \cdot 10^{-5}$ ;
- $B$ représente le coefficient du deuxième degré du polynôme d'estimation de la courbe caractéristique qui s'élève à $-1,0642 \cdot 10^{-3}$ ;
- $C$ représente le coefficient du premier degré du polynôme d'estimation de la courbe caractéristique qui s'élève à $-0,28721$ ;
- $D$ représente l'unité du polynôme d'estimation de la courbe caractéristique qui s'élève à 16,446.

On en déduit donc que, comme pour le plan de coupe {100}, suivant l'adaptation à faire entre le spiral obtenue à partir d'un plan de coupe {111} d'un silicium monocristallin et le balancier (volant d'inertie) pour former le résonateur, un des modes de réalisation A, B, C, D, E sera plus favorisé que les autres. On note donc comme précédemment que le choix des plans de coupe {100} ou {111} n'a pas une influence déterminante.

Au vu de l'explication ci-dessus, on comprend donc que l'enseignement décrit permet de réaliser d'autres types de résonateurs mécaniques thermocompensés comme, par exemple, du type MEMS.

**Revendications**

1. Résonateur mécanique thermocompensé comportant une lame enroulée sur elle-même formant au moins une spire et couplée avec un volant d'inertie, ladite lame ayant une âme de section polygonale comportant du silicium monocristallin **caractérisé en ce que** ladite âme comporte, au moins sur une de ces faces, un revêtement ($b_1$, $b_3$, $h_1$, $h_3$) permettant de rendre ledit résonateur moins sensible aux variations de température et, sur au moins une autre face, aucun revêtement.

2. Résonateur thermocompensé comportant une lame enroulée sur elle-même formant au moins une spire et couplée avec un volant d'inertie, ladite lame ayant une âme de section polygonale comportant du silicium monocristallin et étant recouverte par un revêtement permettant de rendre ledit résonateur moins sensible aux variations de température **caractérisé en ce qu'**au moins deux faces adjacentes de l'âme comportent des revêtements ($b_1$, $b_3$, $h_1$, $h_3$) ayant des épaisseurs différentes.

3. Résonateur selon la revendication 1 ou 2, **caractérisé en ce que** la section de la lame est un quadrilatère dont les faces sont identiques deux à deux.

4. Résonateur selon l'une des revendications précédentes, **caractérisé en ce que** le dépôt dudit revêtement ($h_1$, $h_3$) est réalisé sur les faces parallèles par rapport au plan ($A_1$) de flexion de la lame.

5. Résonateur selon l'une des revendications précédentes, **caractérisé en ce que** le revêtement ($b_1$, $b_3$, $h_1$, $h_3$) comporte du dioxyde de silicium.

6. Résonateur selon l'une des revendications précédentes, **caractérisé en ce que** l'âme est réalisée à partir d'une plaque d'un plan de coupe {100} de silicium monocristallin.

7. Résonateur selon l'une des revendications 1 à 5, **caractérisé en ce que** l'âme est réalisée à partir d'une plaque d'un plan de coupe {111} de silicium monocristallin.

8. Résonateur selon la revendication 6, **caractérisé en ce que** les épaisseurs de revêtement desdites faces deux à deux suivent sensiblement la relation:

$$Y = A \cdot X^3 + B \cdot X^2 + C \cdot X + D$$

Où:

    - $Y$ représente le pourcentage d'épaisseur du revêtement sur les faces parallèles à l'axe ($A_1$) de flexion de la lame par rapport à la hauteur (h) totale de la lame ;
    - $X$ représente le pourcentage d'épaisseur du revêtement sur les faces perpendiculaires à l'axe ($A_1$) de flexion de la lame par rapport à la base (b) totale de la lame ;
    - $A$ représente le coefficient du troisième degré du polynôme d'estimation de la courbe caractéristique qui s'élève à $-3,5302.10^{-5}$ ;
    - $B$ représente le coefficient du deuxième degré du polynôme d'estimation de la courbe caractéristique qui s'élève à $-1,114.10^{-3}$ ;
    - $C$ représente le coefficient du premier degré du polynôme d'estimation de la courbe caractéristique qui s'élève à $-0,29152$ ;
    - $D$ représente l'unité du polynôme d'estimation de la courbe caractéristique qui s'élève à 15,522.

9. Résonateur selon la revendication 7, **caractérisé en ce que** les épaisseurs de revêtement desdites faces deux à deux suivent sensiblement la relation :

$$Y = A \cdot X^3 + B \cdot X^2 + C \cdot X + D$$

Où:

    - $Y$ représente le pourcentage d'épaisseur du revêtement sur les faces parallèles à l'axe ($A_1$) de flexion de la lame par rapport à la hauteur (h) totale de la lame ;
    - $X$ représente le pourcentage d'épaisseur du revêtement sur les faces perpendiculaires à l'axe ($A_1$) de flexion de la lame par rapport à la base (b) totale de la lame ;
    - A représente le coefficient du troisième degré du polynôme d'estimation de la courbe caractéristique qui s'élève à $-3,5565.10^{-5}$ ;
    - $B$ représente le coefficient du deuxième degré du polynôme d'estimation de la courbe caractéristique qui s'élève à $-1,0642.10^{-3}$ ;
    - $C$ représente le coefficient du premier degré du polynôme d'estimation de la courbe caractéristique qui s'élève à $-0,28721$ ;
    - $D$ représente l'unité du polynôme d'estimation de la courbe caractéristique qui s'élève à 16,446.

10. Pièce d'horlogerie **caractérisée en ce qu'**elle comporte au moins un résonateur mécanique conforme à l'une des revendications précédentes.

**Patentansprüche**

1. Wärmekompensierter mechanischer Resonator, der ein Plättchen aufweist, das auf sich selbst gewickelt ist und wenigstens eine Windung bildet und mit einem Schwungrad gekoppelt ist, wobei das Plättchen einen Kern mit polygonalem Querschnitt besitzt, der monokristallines Silicium enthält, **dadurch gekennzeichnet, dass** der Kern wenigstens auf einer dieser Flächen eine Beschichtung ($b_1$, $b_3$, $h_1$, $h_3$) aufweist, die ermöglicht, den Resonator weniger empfindlich gegenüber Temperaturschwankungen zu machen, und auf wenigstens einer anderen Fläche keine Beschichtung aufweist.

2. Wärmekompensierter Resonator, der ein Plättchen aufweist, das auf sich selbst gewickelt ist und wenigstens eine Windung bildet und mit einem Schwungrad gekoppelt ist, wobei das Plättchen einen Kern mit polygonalem Querschnitt besitzt, der monokristallines Silicium enthält und mit einer Beschichtung abgedeckt ist, die ermöglicht, den Resonator weniger empfindlich gegenüber Temperaturschwankungen zu machen, **dadurch gekennzeichnet, dass** wenigstens zwei benachbarte Flächen des Kerns Beschichtungen ($b_1$, $b_3$, $h_1$, $h_3$) aufweisen, die unterschiedliche Dicken haben.

3. Resonator nach Anspruch 1 oder 2, **dadurch gekennzeichnet, dass** der Querschnitt des Plättchens vierseitig ist und die Flächen paarweise gleich sind.

**4.** Resonator nach einem der vorhergehenden Ansprüche, **dadurch gekennzeichnet, dass** die Ablagerung der Beschichtung ($h_1$, $h_3$) auf den parallelen Flächen in Bezug auf die Biegeebene ($A_1$) des Plättchens verwirklicht ist.

**5.** Resonator nach einem der vorhergehenden Ansprüche, **dadurch gekennzeichnet, dass** die Beschichtung ($b_1$, $b_3$, $h_1$, $h_3$) Siliciumdioxid enthält.

**6.** Resonator nach einem der vorhergehenden Ansprüche, **dadurch gekennzeichnet, dass** der Kern anhand einer Platte einer Schnittebene {100} von monokristallinem Silicium verwirklicht ist.

**7.** Resonator nach einem der Ansprüche 1 bis 5, **dadurch gekennzeichnet, dass** der Kern anhand einer Platte einer Schnittebene {111} von monokristallinem Silicium verwirklicht ist.

**8.** Resonator nach Anspruch 6, **dadurch gekennzeichnet, dass** die Dicken der Beschichtungen der Flächen paarweise der folgenden Beziehung gehorchen:

$$Y = A \cdot X^3 + B \cdot X^2 + C \cdot X + D,$$

wobei

- Y den Dickenanteil der Beschichtung auf den zu der Biegungsachse ($A_1$) des Plättchens parallelen Flächen in Bezug auf die Gesamthöhe (h) des Plättchens repräsentiert;
- X den Dickenanteil der Beschichtung auf den zu der Biegungsachse ($A_1$) des Plättchens senkrechten Flächen in Bezug auf die Gesamtbasis (b) des Plättchens repräsentiert;
- A den Koeffizienten des dritten Grades des Schätzpolynoms der charakteristischen Kurve repräsentiert und $-3{,}5302 \cdot 10\text{-}5$ beträgt;
- B den Koeffizienten des zweiten Grades des Schätzpolynoms der charakteristischen Kurve repräsentiert und $-1{,}114 \cdot 10^{-3}$ beträgt;
- C den Koeffizienten des ersten Grades des Schätzpolynoms der charakteristischen Kurve repräsentiert und $-0{,}29152$ beträgt;
- D die Einheit des Schätzpolynoms der charakteristischen Kurve repräsentiert und $15{,}522$ beträgt.

**9.** Resonator nach Anspruch 7, **dadurch gekennzeichnet, dass** die Beschichtungsdicken der Flächen paarweise der folgenden Beziehung gehorchen:

$$Y = A \cdot X^3 + B \cdot X^2 + C \cdot X + D$$

wobei

- Y den Dickenanteil der Beschichtung auf den zu der Biegungsachse ($A_1$) des Plättchens parallelen Flächen in Bezug auf die Gesamthöhe (h) des Plättchens repräsentiert;
- X den Dickenanteil der Beschichtung auf den zu der Biegungsachse ($A_1$) des Plättchens senkrechten Flächen in Bezug auf die Gesamtbasis (b) des Plättchens repräsentiert;
- A den Koeffizienten des dritten Grades des Schätzpolynoms der charakteristischen Kurve repräsentiert und $-3{,}5565 \cdot 10^{-5}$ beträgt;
- B den Koeffizienten des zweiten Grades des Schätzpolynoms der charakteristischen Kurve repräsentiert und $-1{,}0642 \cdot 10^{-3}$ beträgt;
- C den Koeffizienten des ersten Grades des Schätzpolynoms der charakteristischen Kurve repräsentiert und $-0{,}28721$ beträgt;
- D die Einheit des Schätzpolynoms der charakteristischen Kurve repräsentiert und $16{,}446$ beträgt.

**10.** Zeitmessgerät, **dadurch gekennzeichnet, dass** es wenigstens einen mechanischen Resonator nach einem der vorhergehenden Ansprüche umfasst.

**Claims**

**1.** Thermocompensated mechanical resonator including a strip wound around itself to form at least one coil and is coupled to an inertia fly wheel, said strip having a core, which is of polygonal section, includes single crystal silicon, **characterized in that** the core includes, on at least one of the faces thereof, a coating ($b_1$, $b_3$, $h_1$, $h_3$) for making said resonator less sensitive to temperature variations, and at least one other face has no coating.

**2.** Thermocompensated resonator including a strip wound around itself to form at least one coil and is coupled to an inertia fly wheel, said strip having whose polygonal core includes single crystal silicon and is coated with a coating for making said resonator less sensitive to temperature variations, **characterized in that** at least two adjacent faces of the core include coatings ($b_1$, $b_3$, $h_1$, $h_3$) having different thicknesses.

**3.** Resonator according to claim 1 or 2, **characterized in that** the section of the strip is a quadrilateral whose faces are in identical pairs.

**4.** Resonator according to any of the preceding claims, **characterized in that** said coating is deposited ($h_1$, $h_3$) on the faces parallel to the bending plane ($A_1$) of the strip.

**5.** Resonator according to any of the preceding claims, **characterized in that** the coating ($b_1$, $b_3$, $h_1$, $h_3$) includes silicon dioxide.

**6.** Resonator according to any of the preceding claims, **characterized in that** the core is made from a {100} single crystal silicon wafer.

**7.** Resonator according to any of claims 1 to 5, **characterized in that** the core is made from a {111} single crystal silicon wafer.

**8.** Resonator according to claim 6, **characterized in that** the coating thickness of said pairs of faces approximately follow the relation:

$$Y = A \cdot X^3 + B \cdot X^2 + C \cdot X + D$$

Where:

  - $Y$ is the percentage of coating thickness on the faces parallel to the bending axis ($A_1$) of the strip relative to the total strip height (h);
  - $X$ is the percentage of coating thickness on the faces perpendicular to the bending axis ($A_1$) of the strip relative to the total base (b) of the strip;
  - $A$ is the cubic coefficient of the polynomial estimate of the characteristic curve which is $-3.5302.10^{-5}$;
  - $B$ is the quadratic coefficient of the polynomial estimate of the characteristic curve which is $-1.114.10^{-3}$;
  - $C$ is the linear coefficient of the polynomial estimate of the characteristic curve which is $-0.29152$;
  - $D$ is the unit of the polynomial estimate of the characteristic curve which is 15.522.

**9.** Resonator according to claim 7, **characterized in that** the coating thickness of said pairs of faces approximately follow the relation:

$$Y = A \cdot X^3 + B \cdot X^2 + C \cdot X + D$$

Where:

  - $Y$ is the percentage of coating thickness on the faces parallel to the bending axis ($A_1$) of the strip relative to the total strip height (h);
  - $X$ is the percentage of coating thickness on the faces perpendicular to the bending axis ($A_1$) of the strip relative to the total base (b) of the strip;
  - $A$ is the cubic coefficient of the polynomial estimate of the characteristic curve which is $-3.5565.10^{-5}$;
  - $B$ is the quadratic coefficient of the polynomial estimate of the characteristic curve which is $-1.0642.10^{-3}$;
  - $C$ is the linear coefficient of the polynomial estimate of the characteristic curve which is $-0.28721$;
  - $D$ is the unit of the polynomial estimate of the characteristic curve which is 16.446.

**10.** Timepiece **characterized in that** it includes at least one mechanical resonator according to any of the preceding claims.

Fig. 2

Fig. 1

Fig. 3

Fig. 5

Fig. 4

{ 100 }

Fig. 7

Fig. 6

EP 2 284 628 B1

{ 100 }

← T = 50°
← T = 45°
← T = 40°
← T = 35°
← T = 30°
← T = 25°
← T = 20°
← T = 15°
← T = 10°
← T = 5°
← T = 0°

$\Delta F$

1.003
1.002
1.001
1
0.999
0.998
0.997

$h_1 + h_3$ [%h]

$b_1 + b_3$ [%b]

Fig. 8

A- { 100 }

Fig. 9

B- { 100 }

Fig. 10

$\Delta F$

$h_1 + h_3$ [%h]

← T = 50°C
← T = 45°C
← T = 40°C
← T = 35°C
← T = 30°C
← T = 25°C
← T = 20°C
← T = 15°C
← T = 10°C
← T = 5°C
← T = 0°C

EP 2 284 628 B1

Fig. 11

EP 2 284 628 B1

A- { 100 }

Fig. 12

EP 2 284 628 B1

Fig. 13

Fig. 14

A- { 111 }

Fig. 15

EP 2 284 628 B1

B- { 111 }

$\Delta F$

h₁+h₃ [%h]

Fig. 16

Fig. 17

EP 2 284 628 B1

**EP 2 284 628 B1**

## RÉFÉRENCES CITÉES DANS LA DESCRIPTION

**Documents brevets cités dans la description**

- EP 1422436 A

- WO 2008043727 A